# EUROPEAN PATENT APPLICATION

(11) **EP 0 955 796 A2**
(43) Date of publication of application: **10.11.1999**
(21) Application number: 99303377.8
(22) Date of filing: 29.04.1999
(51) Int. Cl.: H05K 7/12, H01R 23/70

(54) **System for fastening an article to a board**

(30) Priority: 04.05.1998 US 84092 P; 30.09.1998 US 102432 P; 27.01.1999 US 117418 P
(71) Applicant: THE WHITAKER CORPORATION, Wilmington, Delaware 19808 (US)
(72) Inventor: McCleerey, Earl W., Mechanicsburg, Pennsylvania 17055 (US)
(74) Representative: Johnstone, Douglas Ian

(57) **Abstract**

A processor module retention member (200) is connected to an upper surface of a circuit board (14) by means of a deflectable leg (202) which is integral with the member (200). A shaft (212) of the leg (202) is deflected by means of a peg (204) which is forced through a peg receiving hole (206) in the member (200) and a mounting hole (24) in the circuit board (14) and into contact with a camming surface (208) on a foot portion (210) of the leg (202) thereby urging the foot (210) into retaining engagement with a lower surface of the circuit board (14). Prior to installation, the peg (204) may be force fitted into the peg receiving hole (206) or may be integrally joined to the member (200) by frangible sections. Each mounting hole may receive a pair of legs which deform resiliently as they pass therethrough.

## Description

This relates to the field of fasteners and more particularly to components mountable to a circuit board.

In computers and other electronic equipment, circuit boards are utilized to which are mounted numerous electrical and electronic components. Smaller circuit cards are utilized to establish electrical connections to a larger circuit board in a manner that permits removal and disconnection, by inserting an edge of the card into a receptacle connector mounted on the board and containing an array of contacts connected to circuits of the board; contact sections of the contacts are exposed within a card-receiving cavity of the connector that engage circuit pads on the card surfaces upon card insertion. It has become useful to secure certain cards within larger modules so that components mounted on the card are protected by the module covers during handling. Such modules need to be accurately guided during mating with the receptacle connector so that the leading end of the enclosed card is accurately received into the card-receiving cavity of the connector, since the module covers inhibit accurate visual alignment of the card with the cavity. It is known to provide elongate guide members projecting from the board from ends of receptacle connectors to facilitate mating in similar situations. Such elongate guide members may be mounted on the circuit board substantially prior to their actual use during module mating.

In one system for fastening a retention member to a board, a separate component is mounted to a mounting flange of the retention module such that a pair of legs extend beneath the board mounting face and through a mounting hole of the board. Thereafter, a peg is urged into a hole through the component between the legs, urging the legs apart to engage locking sections along outer sides of the legs beneath the board.

It is desired to provide an improved system for fastening the guide or retention modules to the circuit board.

The fastening system of the present invention may be used on retention members for mounting to a circuit board or panel, for example, or may be used on electrical connectors. Each leg extends integrally from the retention member (or from a connector housing) along the board-mounting face, and is insertable into a mounting hole of a circuit board. The leg includes an integral locking section along one side to latch beneath the board upon insertion therethrough. A locking member such as a peg is then pushed into the mounting hole beside the leg to deflect the leg laterally to lock the latch in position beneath the board. The locking member may be secured to the retention member in a prelocked position.

In a second embodiment, a pair of legs are inserted into the same mounting hole, and the peg is urged between the pair of legs, engaging camming sections of the legs and camming them both outwardly in opposed directions to lock their locking sections beneath the board.

Embodiments of the present invention will now be described by way of example with reference to the accompanying drawings.
FIGURE 1 is an isometric view of an assembly including a pair of retention members mounted to a circuit board, with a processor module positioned to be inserted therebetween;
FIGURE 2 is an isometric view of the retention members of FIG. 1 with the retention members pivoted to recumbent positions when not in use;
FIGURES 3 and 4 are isometric views of one of the retention members with a fastening pin in its fully inserted position;
FIGURE 5 is an isometric view of a fastening pin;
FIGURES 6 and 7 are section views of the fastening system of the retention member of FIGS. 1 to 5, with a locking pin shown prior to and after insertion;
FIGURE 8 is an isometric view of the lower member of the retention assembly with pin removed;
FIGURE 9 is an isometric view of another embodiment of retention member, having a pair of legs for being secured in a common mounting hole of a board, and showing a fastening pin molded integrally to the retention member prior to board mounting;
FIG. 10 is a plan view of another embodiment of leg shown disposed within a board hole prior to locking by a peg, and adjacent to the leg is shown the peg-receiving hole of the component being mounted to the board;
FIG. 11 is a bottom view of the leg of FIG. 10 beneath the circuit board after locking by the peg; and
FIGS. 12 to 14 are elevational cross-section views of the component of FIGS. 10 and 11 showing the leg being inserted into the board hole, the leg fully inserted when the component is placed onto the board, and after full actuation of the peg fully locking the component to the board, respectively.

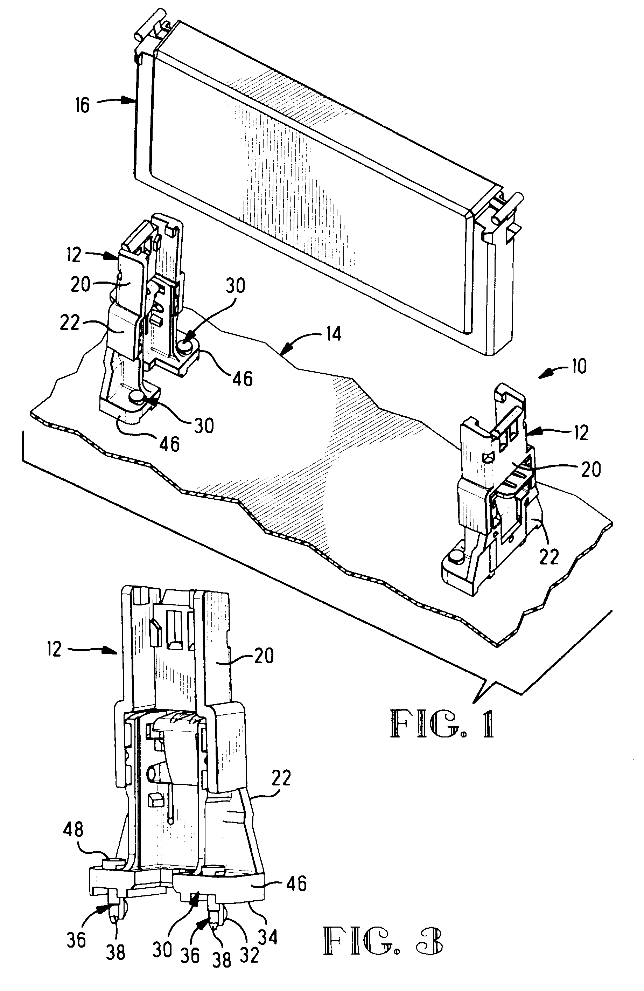

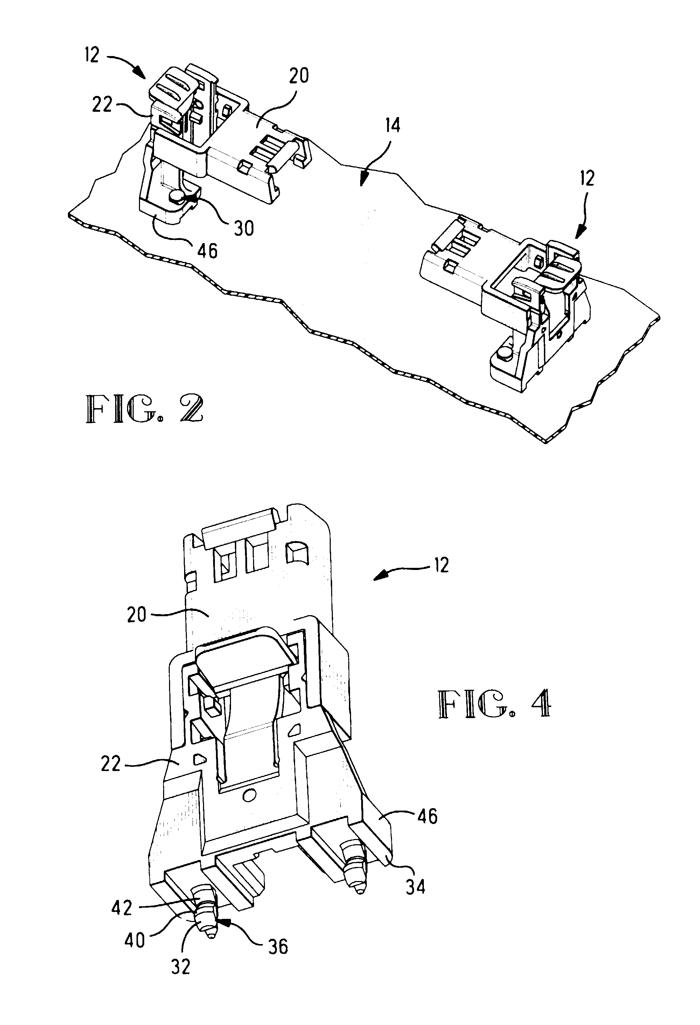

Retention system 10 of FIGS. 1 to 8 comprises a pair of retention member assemblies 12 mounted onto a circuit board 14 and spaced apart to receive therebetween a processor module 16 that will mate with a receptacle connector (not shown) mountable to the circuit board between the retention member assemblies 12. Each retention member assembly 12 includes an upper pivotable section 20 pivotably secured to a lower mounted section 22, and in FIG. 2 the assemblies 12 are seen in their recumbent positions when a processor module is not secured therebetween, facilitating handling and shipping of the circuit board.

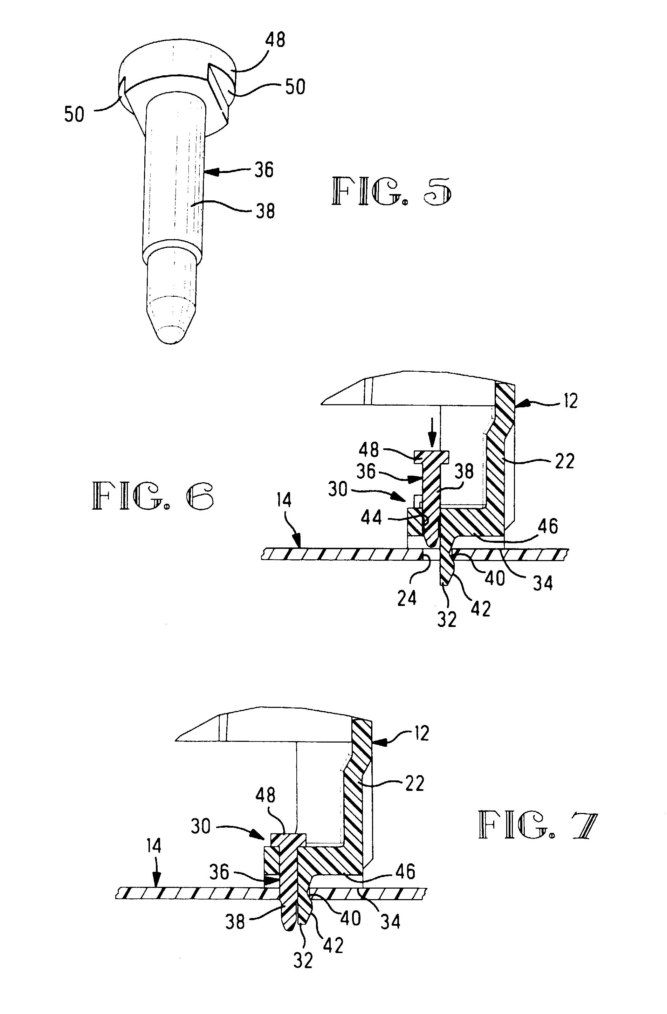

In FIGS. 3 and 4 is seen a retention member assembly 12, with upper section 20 upright with respect to lower section 22. Also seen is the board-fastening system 30 of the present invention. A board mounting leg 32 integral with lower section 22 depends beneath board-mounting face 34, and therebeside is a locking member such as locking peg 36 in its fully inserted position with its locking shaft 38 extending beside leg 32. Both the leg and the locking peg would be disposed in common in a mounting hole 24 of circuit board 14, as seen in FIG. 7.

It is also possible to utilize as a locking member a screw (not shown), such as a self-tapping screw, for example, in lieu of peg 36, threaded either through aperture 44 or threaded upwardly from the bottom of circuit board 14 to deflect the leg laterally into a locking position.

Referring now to FIGS. 5 to 7, board mounting leg is seen to have a generally semicylindrical shape. A locking section 40 extends outwardly from outer surface 42 to lock beneath the far surface of circuit board 14 at the periphery of mounting hole 24, when locking peg 36 has been fully inserted through mounting hole 24. Locking shaft 38 extends through aperture 44 of mounting flange 46 of lower retention member section 22, and locking peg 36 includes an enlarged head 48 that abuts mounting flange 46 when locking peg 36 has been fully inserted through both aperture 44 and mounting hole 24.

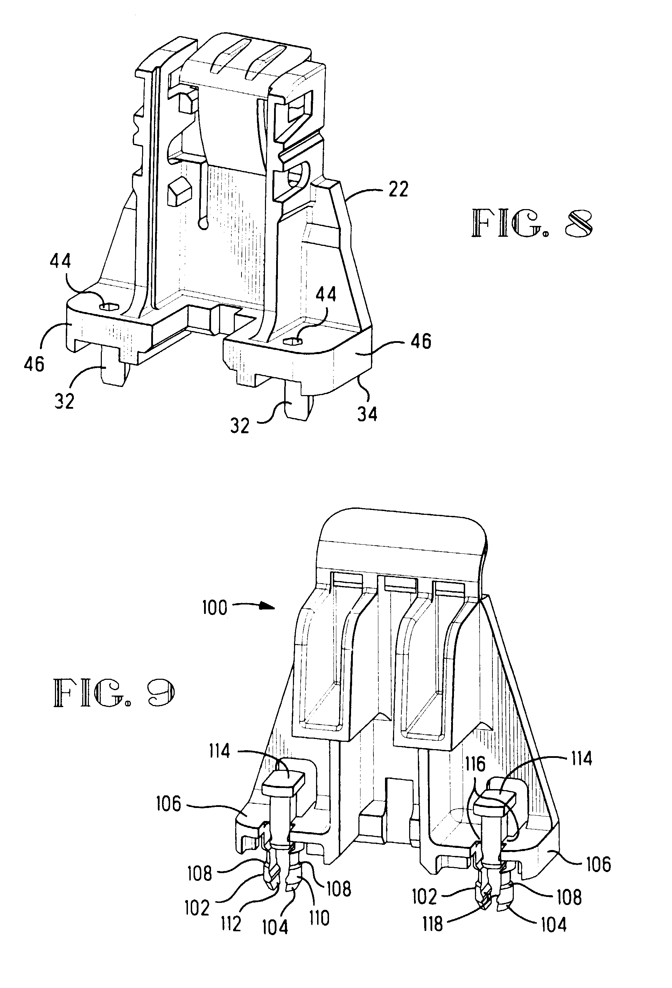

Preferably, locking shaft 38 is cylindrical in cross-section, while aperture 44 of each mounting flange 46 is hexagonal as seen in FIG. 8, such that locking shaft 38 is held in a force fit in aperture 44 in a first or prelocking position as shown in FIG. 6. Such force fit allows locking peg 36 to self-retain to retention member assembly 12 prior to being mounted onto a circuit board, so that the retention member assembly 12 can be handled as a unit and thus simplifying assembly since no separate fasteners are needed requiring handling during mounting. Also, enlarged head 48 of locking peg 36 may include undercuts 50 permitting grasping or prying by tools for removal if desired.

FIG. 9 illustrates another embodiment of retention member 100 of thermoplastic material, wherein the fastening system is defined by a pair of legs 102,104 coextending from each mounting flange 106 to be inserted into a common mounting hole of a circuit board (not shown). Each leg 102,104 of each pair includes locking sections 108 along outer surfaces 110, and a gap 112 separates the legs. During insertion into a board mounting hole, the legs are deflectable toward each other until locking sections 108 pass through the board mounting hole, after which the legs will resile to move the locking sections under the board at the mounting hole periphery. A locking peg 114 is seen in a first position in gap 112, poised to be force downwardly between the legs 102,104 after insertion into a board mounting hole, thereafter to lock the locking sections under the board. Also shown in FIG. 9, locking peg 114 is molded integrally to the mounting flanges, being joined thereto by frangible sections 116; frangible sections 116 are broken when locking peg 114 is urged downwardly into gap 112.

Optionally, as shown in FIG. 9, legs 102,104 may include camming surfaces 118 along inner surfaces defining gap 112, such that locking peg 114 will cam legs 102,104 outwardly for locking, and legs 102,104 need not deflect together during their insertion through the board mounting hole, thus being insertable without generating resistive forces during mounting.

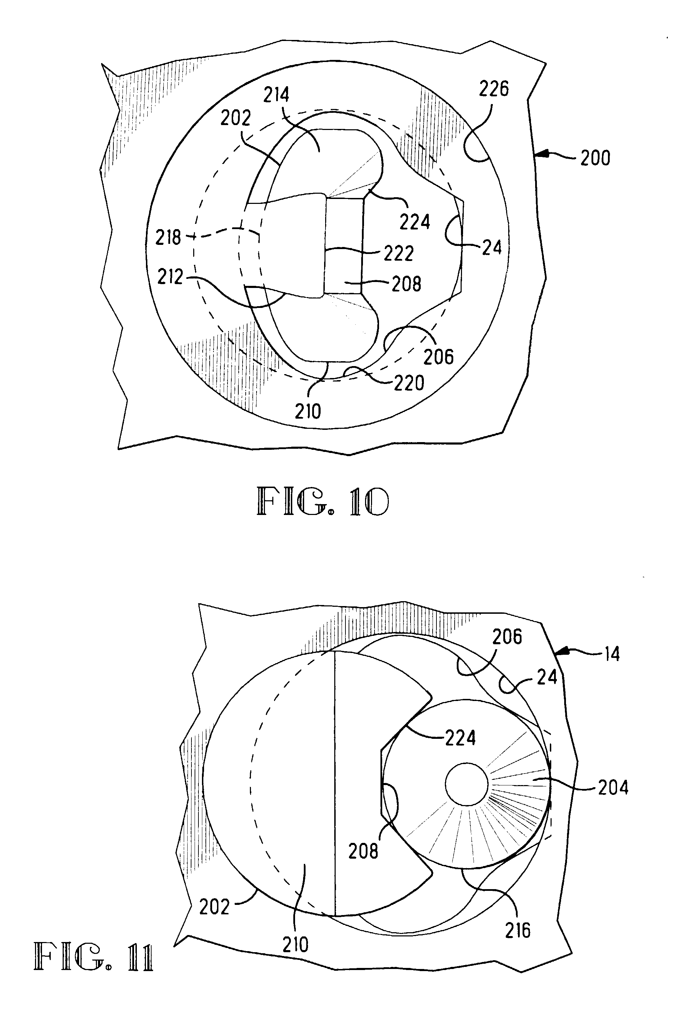

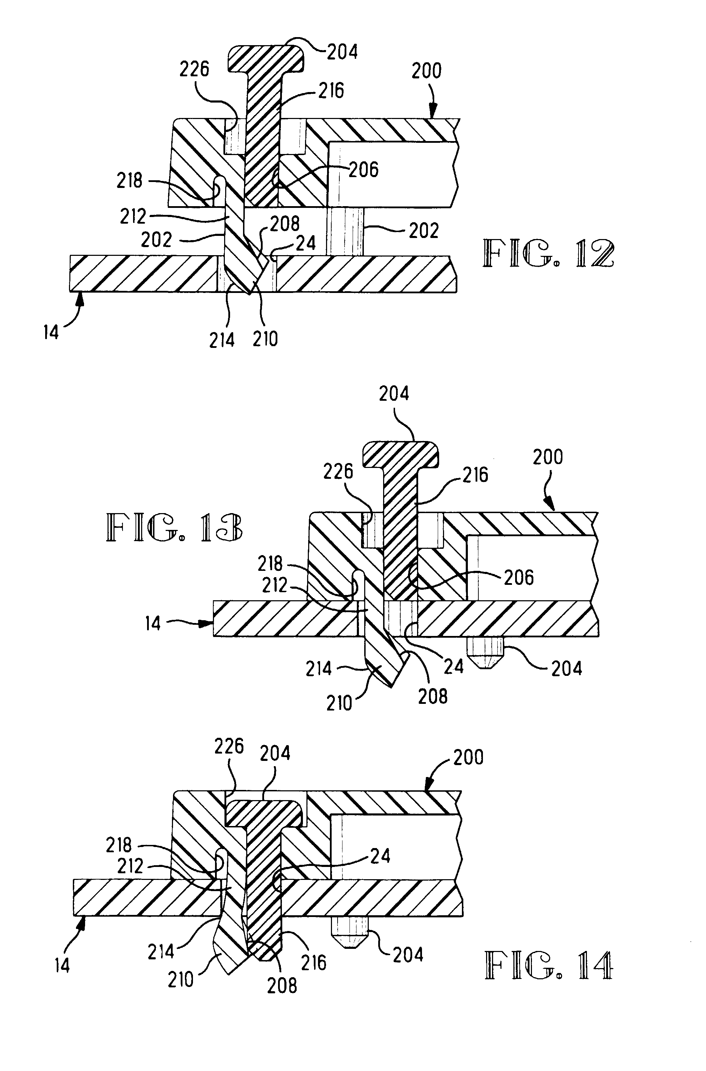

In another embodiment of retention leg, a component 200 is shown in FIGS. 10 to 14 that may be a memory card socket; the leg 202 is adapted for the socket to be initially placed onto the board with zero force; in other words, the leg is designed to not require deflection during being inserted through mounting hole 24 of board 14, as is clear from FIG. 12. Viewed from above through recess 226 for the enlarged peg head, leg 202 is seen in FIG. 10 to have a widened foot portion 210, its shape suggestive of a horse's hoof, that includes a camming surface 208 engageable by peg 204 (FIGS. 11 to 14) to actuate the leg, deflecting the leg into the locking position beneath the circuit board. The outline of a core pin hole 220 is seen in FIG. 10 indicating how the leg is moldable in a simple two-draw molding procedure; core pin hole 220 also defines a substantial portion of the periphery of a "hexagonal" peg-receiving hole 206, while a peg-adjacent surface 222 of the deflectable shaft 212 of leg 202 defines an additional portion of that periphery.

A peg 204, already partially inserted into peg-receiving hole 206 similarly to fastening pin 36 (FIG. 6), is then fully urged through peg-receiving hole 206 to engage angled camming surface 208 adjacent the foot portion 210 of leg 202, whereafter foot portion 210 is deflected laterally to bend the shaft 212 of leg 202 until the outwardly facing surface 214 of foot portion 210 is pressed against the lower board surface of board 14 adjacent the periphery of mounting hole 24, while shaft 216 of peg 204 is pressed against the adjacent side wall of mounting hole 24, all thus locking the leg and the socket to the board, as shown in FIG. 14. Preferably a clearance hole 218 is provided beside shaft 212 of leg 202 within socket 200 to facilitate deflection. Additionally, preferably leading end portion 210 provides a seat 224 for the peg leading end adjacent to camming surface 208 to assure control of the deflection of leg 202 in the desired direction.

The fastening system of the present invention may easily be utilized by housings of electrical connectors, simplifying board mounting, and may also be used for panel mounting.

## Claims

1. A system (30) for fastening an article (12) to a panel (14) at a mounting hole (24) of the panel (14), comprising:
a body of said article, at least one leg (32) depending integrally from a panel-proximate surface (34) of the body adapted to extend into said mounting hole (24) along a near surface of said panel (14) with an end of said leg (32) extending beyond a far surface of said panel (14), an aperture (44) through said article body adjacent said at least one leg (32), and a locking member (36) adapted to be urged through said aperture (44) along a first side of said leg (32) and at least into said mounting hole (24) of said panel (14) beside said leg (32),
said leg (32) including a locking section (40) proximate an end of said leg (32) and along a second side (42) thereof generally opposed to said first side, and
said locking member (36) having a shape and dimension to self-retain in said mounting hole (24) beside said leg (32), and further having a sufficient length that upon being inserted into said aperture (44), a portion thereof engages said first side of said leg (32) to at least lock said locking section (40) beneath said panel far surface at a periphery of said mounting hole (24), thus locking said locking section (40) beneath said panel far surface.

2. The fastening system (30) according to claim 1 wherein said locking member (36) defines a force fit in said mounting hole (24) beside said leg (32).

3. The fastening system according to claim 1 or claim 2 wherein only one said leg (32) extends through said mounting hole (24), and said locking member (36) includes a locking shaft (38) that is resilient to be deflectable away from said first side of said one leg (32) upon full insertion into said mounting hole (24) into said locking position, facilitating said force fit and enhancing the locking of said locking section (40) beneath said panel far surface.

4. The fastening system according to claim 1 or 2 wherein said body (106) has a pair of said legs (102,104) with said first sides thereof spaced apart therealong, and said pair of legs (102,104) being shaped and dimensioned to be inserted into said mounting hole (24) in common, and said locking member (114) is insertable into said mounting hole (24) between said legs (102,104) to lock locking sections (108) of both said legs (102,104) beneath said panel far surface.

5. The fastening system according to claim 4 wherein said locking member (114) includes opposed planar sides engageable with first sides of respective ones of both said legs (102,104).

6. The fastening system (30) according to any preceding claim wherein said locking member (36) is initially partially inserted into said aperture (44,206) of said article body to define a force fit therein in a prelocking position prior to mounting of said article on said panel (14).

7. The fastening system (30) according to any one of claims 1 to 5 wherein said body (106) is of plastic material and said locking member (114) is initially integrally joined to said body in a prelocked position by frangible sections (116).

8. The fastening system (30) according to any preceding claim wherein each said leg (32) is deflected during insertion through said mounting hole (24), whereafter said leg (32) resiles to move said locking section (40) beneath said panel far surface, said end of each said leg (32) is chamfered along said second side to facilitate leg deflection upon initial engagement with said panel (14) during mounting of said article thereto, and said locking section (40) includes a panel-engaging surface angled outwardly and slightly upwardly.

9. The fastening system according to claim 1 wherein each said at least one leg (102,104,202) includes a camming surface (118,208) along said second side and protruding outwardly therefrom proximate an end of said leg (102,104,202) engageable by said portion of said locking member (114,204) upon insertion of said locking member (114,204) into said mounting hole (24) and movement thereof to said locking position, to deflect said end of said leg (102,104,202) laterally outwardly to move said locking section (108,214) beneath said panel far surface.

10. The fastening system according to claim 9 wherein said camming surface (208) is defined in a seat (224) along a foot (210) of said leg (202) that protrudes outwardly from said first side (222) of said leg when undeflected, and a leading end of said locking member (204) is adapted to be received into and along said seat (224) to controllably deflect said foot (210) laterally outwardly to move said foot partially under said panel far surface.

11. The fastening system according to any preceding claim wherein said body includes a clearance hole (218) extending thereinto spaced from said first side of said leg (202) to facilitate deflection.
